# EUROPÄISCHE PATENTSCHRIFT

(11) **EP 2 139 049 B1**
(45) Veröffentlichungstag und Bekanntmachung des Hinweises auf die Patenterteilung: **26.10.2011**
(21) Anmeldenummer: 08405163.0
(22) Anmeldetag: 25.06.2008
(51) Int. Cl.: H01L 31/18, B23K 26/08, H01L 21/683

(54) **Vorrichtung zur Strukturierung eines Solarmoduls**
Device for structuring a solar module
Dispositif destiné à structurer un module solaire

(43) Veröffentlichungstag der Anmeldung: 30.12.2009
(73) Patentinhaber: ATEC Holding AG, 6052 Hergiswil (CH)
(72) Erfinder: Raible, Adrian, 1255 Veyrier (CH); Bartlome, Richard, 1197 Prangins VD (CH); Sinquin, Yann, 2000 Neuchatel (CH)
(74) Vertreter: EGLI-EUROPEAN PATENT ATTORNEYS

(56) Entgegenhaltungen:
- EP-A- 1 728 581
- EP-A- 1 880 790
- WO-A-2007/042905
- GB-A- 2 439 529
- JP-A- 6 071 475
- JP-A- 10 235 486
- JP-A- 2001 111 078
- JP-A- 2001 119 048
- JP-A- 2005 001 264
- JP-A- 2007 098 910
- JP-A- 2007 142 000
- US-A- 5 246 331
- US-A- 5 897 798
- US-A1- 2006 186 100
- US-B1- 6 222 155

## Beschreibung

Die Erfindung betrifft eine Vorrichtung zur Strukturierung eines Solarmoduls nach dem Oberbegriff des Anspruchs 1.

Solarmodule photovoltaischer Anlagen weisen im wesentlichen flache Glasplatten auf, die einseitig beschichtet sind. Die Beschichtung besteht meist aus mehreren übereinanderliegenden Schichten, von denen wenigstens eine Schicht elektrisch leitend ist. Aus herstellungstechnischen Gründen wird das Glasmodul zusammenhängend mit der Beschichtung versehen. Zur Erzeugung eines annehmbaren hohen elektrischen Stroms muss die aufgebrachte Beschichtung in einzelne Abschnitte unterbrochen werden. Neben einer rein mechanischen Strukturierung der Oberfläche durch entsprechende Werkzeuge hat sich eine optische Strukturierung dieser Solarmodule durchgesetzt.

Bei der optischen Strukturierung wird die Beschichtung durch einen Laser hergestellt, der mit einigermaßen Präzision dünne bis sehr dünne Unterbrechungen in die Beschichtung brennt.

Aus der DE 10 2006 033 296 A1 ist eine Anlage zur Strukturierung von Solarmodulen bekannt. Diese Strukturierungsanlage weist ein Transportsystem auf, mit dem ein Glasmodul innerhalb der Anlage transportierbar ist. Zum Transport und Halten des Solarmoduls ist das Transportsystem mit einer Vielzahl von Luftdüsen ausgestattet, durch die das Solarmodul auf einem Luftlager schwebt. Die Beschichtung befindet sich auf der dem Transport abgelegenen Oberseite des Solarmoduls. Unterhalb des Transportsystems und der zu strukturierenden Glasplatte ist ein Strukturierungswerkzeug, nämlich ein Laser, angeordnet. Der Laser ist quer zu einer Transportrichtung des Solarmoduls verfahrbar.

Zur Strukturierung der Beschichtung wird der Fokus des Lasers auf den Bereich der Beschichtung gelenkt, wobei ein Laserstrahl durch die Glasplatte des Solarmoduls hindurchtritt. Im Fokussierungsbereich des Lasers wird die Beschichtung verdampft, wodurch die erwünschte Unterbrechung herstellbar ist.

Für eine Strukturierung in Längsrichtung des Solarmoduls, welche einer Transportrichtung des Moduls entspricht, muss das Modul über einen Arbeitsbereich des Lasers verfahren werden. Aufgrund der unterhalb der Glasplatte angeordneten Luftdüsen entspricht der Arbeitsbereich nur einem geringen quer zur Transportrichtung verlaufenden Spalt. Das Glas wird zur Strukturierung über diesen Arbeitsbereich verfahren, wobei sich dieses Prozedere so oft wiederholt, bis die Strukturierung des Solarmoduls fertig gestellt ist.

Oberhalb des Arbeitsbereichs ist eine Absaugvorrichtung angeordnet, die die bei der Strukturierung anfallenden Partikel bzw. Abgase von der Oberfläche des Solarmoduls absaugt, die ansonsten liegen blieben und eventuell einem erneuten Strukturierungshub des Lasers in einem auch nur benachbarten Bereich beeinträchtigen könnten.

Aufgrund des Transportsystems, welches unterhalb des Solarmoduls angeordnet ist, ist die Bewegungsfreiheit des Lasers erheblich eingeschränkt. Dieser ist, wie oben dargestellt, nur quer zur Transportrichtung des Solarmoduls beweglich. Zur Strukturierung des Moduls muss dasselbige immer wieder über den Laser bewegt werden. Bewegt werden darf die Glasplatte indes nur äußerst vorsichtig, da aufgrund der Glasstärke die Glasplatte leicht zu Bruch gehen kann. Insbesondere eine hohe Beschleunigung stellt eine Belastung der Glasplatte dar, die zu vermeiden ist. Daraus resultiert eine relativ langsame Bearbeitung des Solarmoduls mit dem Laser. Zudem ist mit der relativ eingeschränkten Beweglichkeit des Lasers eine Limitierung der Genauigkeiten des Fokussierungsbereichs sowie der einzelnen Bahnen zu verzeichnen. Insbesondere kann mit der Anordnung des Lasers und der Bewegung des Glases die Strukturierung nicht nachgeregelt werden, worunter die Genauigkeit und damit die Qualität der Solarmodule leidet.

Aus JP 2005001264 ist eine Vorrichtung zur Strukturierung eines Substrats mit einem Strukturierungswerkzeug zur Erzeugung einer Rille an der Oberfläche des Substrats bekannt, wobei die Vorrichtung eine Halteeinrichtung umfasst, welche das Substrat berührungslos auf einer dem Strukturierungswerkzeug abgewandten Seite haltert, wobei die Halteeinrichtung ein oder mehrere Haltemittel umfasst und das jeweilige Haltemittel zum Ansaugen des Solarmoduls mittels Saugluft ausgebildet ist, wobei durch das jeweilige Haltemittel zur Halterung des Substrats auf der Oberseite des Substrats mittels Druckluft ein Unterdruck erzeugbar ist. Die Haltemittel bzw. die Saugluft und/oder die Druckluft sind derart steuerbar, dass das Substrat (i) senkrecht zum Substrat bewegbar ist, um das Substrat mit dem Strukturierungswerkzeug in Kontakt bringen zu können und (ii) in einer Längsrichtung des Substrats bewegbar ist, um die jeweilige Rille erzeugen zu können.

Eine Aufgabe der Erfindung ist es, eine Vorrichtung der eingangs genannten Art zu verbessern durch schnellere Bearbeitungszeiten und eine höhere Bearbeitungsqualität.

Eine Vorrichtung zur Lösung der erfindungsgemäßen Aufgabe weist die Merkmale des Anspruchs 1 auf. Das Solarmodul wird auf einer dem Strukturierungswerkzeug abgewandten Oberseite gehaltert. Das Solarmodul wird mit einer nach oben weisenden beschichteten Oberseite in die Vorrichtung eingebracht, wo es von einer an dieser Seite angeordneten Halteeinrichtung gehaltert wird. Eine Unterseite des Solarmoduls bleibt somit frei, wobei auch durch die Halteeinrichtung mögliche die Beschichtung verletzende Gefahren minimiert werden. So bleiben beispielsweise herunterfallende Gegenstände nicht auf der Halteeinrichtung liegen. Die Oberseite des Solarmoduls wird nicht an unbeweglichen Gegenständen vorbeigeführt, die Grund einer Beschädigung sein könnten.

Nach einer bevorzugten Ausgestaltung der Erfindung erfolgt eine Halterung des Solarmoduls berührungslos. Durch die berührungslose Halterung wird ebenfalls die Gefahr der Beschädigung des Solarmoduls minimiert. Vorzugsweise wird dünnes und in der Qualität schlechteres Glas zur Fertigung eines Solarmoduls benutzt. Dieses Glas ist aber nicht nur kostengünstiger als hochwertige Flachglase, sondern auch empfindlicher in der Handhabung. Eine berührungslose Handhabung des Solarmoduls kann somit zur Minderung von Beschädigungen beitragen oder sogar vor Glasbruch schützen.

In einer bevorzugten Weiterbildung der Erfindung weist die Halteeinrichtung wenigstens ein, vorzugsweise eine Mehrzahl, Haltemittel auf. Die Haltemittel sind dabei gleichmäßig über die Oberseite des Solarmoduls verteilt. Die gleichmäßige Verteilung reduziert Verformungen in dem Glas und trägt somit zu einer präziseren Strukturierung und Vermeidung von Beschädigungen bei. Zur berührungslosen Halterung wird auf der Oberseite des Solarmoduls mittels Druckluft ein Unterdruck durch die Haltemittel erzeugt. Das Haltemittel saugt durch radial auf die Oberseite des Solarmoduls ausgestoßene Druckluft das Modul an, was als Bernoulli-Prinzip bezeichnet wird. Zwischen Haltemittel, auch Bernoulli-Greifer genannt, und Solarmodul entsteht durch Entweichen der Druckluft ein geringer Spalt. Das Solarmodul schwebt also unterhalb der Halteeinrichtung.

In einer weiteren Ausführungsform der Haltemittel zur berührungslosen Halterung saugt das Haltemittel mittels Saugluft das Modul an. Mittels Druckluft wird gleichzeitig ein Luftkissen gebildet. Das Solarmodul schwebt somit durch die Saugluft gehalten unterhalb der Haltevorrichtung.

Vorzugsweise ist das Strukturierungswerkzeug beweglich unterhalb der Halteeinrichtung angeordnet. Durch den Wegfall einer Halteeinrichtung unter dem Glasmodul kann somit der Raum für das Strukturierungswerkzeug genutzt werden. Die Halteeinrichtung mit den Haltemitteln hält das Solarmodul unbeweglich in einer Position, so dass das Strukturierungswerkzeug unterhalb des Solarmoduls bewegend die Struktur in die Beschichtung aufbringen kann. Zusätzlich verbessert sich die durch den Freiraum unterhalb der Halteeinrichtung auch die Standzeit der Strukturierungsvorrichtung. Bei Glasbruch muss mit der erfindungsgemäßen Vorrichtung nicht das Transportsystem aufwändig gereinigt werden. Glasscherben können einfach in dem Freiraum liegengelassen werden und zu einem späteren Zeitpunkt entfernt werden.

In einer bevorzugten Ausführungsform weist das Strukturierungswerkzeug wenigstens einen Wagen und wenigstens einen Laser, vorzugsweise eine Mehrzahl von Lasern auf. Die Laser sind in einer Längs- und Querrichtung beweglich. Mit der Mehrzahl von Lasern ist eine schnellere Bearbeitungszeit des Solarmoduls möglich, da gleichzeitig mehrere Unterbrechungen in die Beschichtung durch die Laser gebrannt werden können. Die Laser sind auch unempfindlich gegenüber Beschleunigungen, bei denen das Glas der Solarmodule brechen würde. Hierdurch ist zusätzlich eine Beschleunigung bei der Strukturierung zu erzielen.

Gemäß einer vorteilhaften Weiterbildung weist der Wagen einen Träger auf, an dem Laser angeordnet sind, und der auf zwei parallel laufenden Führungen in Längsrichtung verfahrbar ist. Die Laser selber sind an dem Träger in Querrichtung des Strukturierungswerkzeuges verfahrbar. Damit lassen sich die Laser zweidimensional unter dem zu bearbeitenden Solarmodul bewegen. Mit der Zweidimensionalität ist es darüber hinaus möglich, parallele bzw. gleichzeitige Bewegungsabläufe in Längsrichtung und Querrichtung des Solarmoduls auszuführen. Die Führungen sind in Längsrichtung eines Glasmodules angeordnet, so dass der Träger gleichmäßig verfahrbar ist.

Vorteilhafterweise weist der Träger an jeweils einem freien Ende ein Fahrgestell auf, das mit einer der Führungen korrespondiert. Mit dem Fahrgestell wird der Wagen mit den Führungen verbunden, wodurch ein exakter Verlauf des Trägers erzielt wird. Der Träger ist quer zur Längserstreckung der Führungen angeordnet. Der Träger selbst weist ebenfalls eine Führung auf, in der der oder die Laser angeordnet sind. Jeder der Laser ist in einer etwa schuhschachtelgroßen Box untergebracht, wobei die Boxen, wie bereits erwähnt, hohe Beschleunigungen aushalten, bis zu 10 g. Die Boxen mit den Lasern sind auf dem Träger vorzugsweise direkt nebeneinander angeordnet und parallel über eine Längserstreckung des Trägers verfahrbar. Vornehmlich werden die Laser en bloc verfahren, sie können aber auch einzeln gesteuert werden, so dass beispielsweise ein oder mehrere Laser im Bereich des einen Endes, ein oder mehrere Laser an einem anderen Ende und wiederum ein oder mehrere Laser in einem mittleren Bereich des Träger positioniert sein können, um von dort wieder nebeneinander angeordneten zu werden.

Nach ein vorteilhaften Ausgestaltung der Erfindung ist die Führung in einer Ebene mit dem Solarmodul angeordnet. Durch diese Anordnung haben mögliche Bewegungen des Lasers keine Auswirkung auf die Genauigkeit des Fokussierungspunktes des Laser auf der Oberseite der Glasplatte. Die Bewegungen werden als "pitchen", "rollen" und "gieren" bezeichnet und bestimmen eine Drehrichtung von drei durch den Laser verlaufenen Achsen. Es ist aber auch möglich, dass die Ebene des Moduls mit einer Drehachse oder einem der Genauigkeit dienenden Punktes des Fahrgestells korrespondieren zu lassen.

In einem weiteren vorteilhaften Ausführungsbeispiel der Erfindung bleibt ein Raum unterhalb eines Bearbeitungsbereiches des Strukturierungswerkzeuges frei. Mit der Anordnung der Halteeinrichtung oberhalb des Solarmoduls kann man die Vorrichtung wesentlich kleiner ausführen, vor allem aber auch eine die Halteeinheit tragende Konstruktion als einen Kreuztisch ausbilden. Der Kreuztisch ermöglicht eine leichtere für den Kunden leichtere Konstruktion, da die Transportierbarkeit der Vorrichtung erleichtert wird. Der Raum ist somit frei, so dass hier Platz ist für herunterfallende Glasplatten bzw. Scherben von zerbrochenen Glasplatten. Wie oben schon erwähnt, müssen zerbrochene Glasplatten nicht sofort aus der Vorrichtung entfernt werden, da sie einen Arbeitsprozess nicht beeinflussen. Das Säubern kann zu einem späteren Zeitpunkt erfolgen. Alternativ kann auch eine Wanne vorgesehen sein, in der die Scherben aufgefangen werden.

Besonders vorteilhaft ist die Halteeinrichtung um 90° parallel zu einer Ebene des Solarmoduls frei drehbar. Die Strukturierung der Beschichtung auf dem Solarmodul kann sehr komplex sein und unterschiedliche Formen aufweisen. Hierzu ist es nötig, den Laserstrahl nicht nur quer und längs über die Glasplatte laufen zu lassen, sondern auch diagonal oder schräg zu einer Seite der Glasplatte. Mit dem Drehen der Halteeinrichtung und der daran gehalterten Glasplatte können diese Strukturierungsrichtung mühelos bewerkstelligt werden.

Bevorzugt dient die Halteeinrichtung der Absaugung von durch den Laser verdampften und verbrannten Schichtpartikeln. Der Laser erhitzt im Bereich seines Fokussierungsbereichs die Beschichtung des Solarmoduls, wodurch die Beschichtung erhitzt und verbrannt oder verdampft wird. Hierdurch bilden sich auf der Oberseite des Solarmoduls Schmutzpartikel, die zu entfernen sind. Die Halteeinrichtung ist erfindungsgemäß aus einer Mehrzahl Bernoulli-Greifern gebildet, die die Oberseite mit Druckluft beaufschlagen. Die Luft entweicht seitlich aus den Greifern und transportiert somit auf einfache Art und Weise die Schmutzpartikel von dem Solarmodul, die von dem Luftstrom eines oder mehrerer Greifer erfasst werden. Auch können Abgase, die bei der Verbrennung entstehen, durch die starke Strömung seitlich abgeführt werden. Vorzugsweise ist seitlich in einem Bereich der Ränder oder des Solarmoduls oder über diesem eine Absaugvorrichtung vorgesehen, die die Abgase und Schmutzpartikel absaugt.

Gemäß einer vorteilhaften Ausbildung ist eine Positionierhilfe seitlich zum Solarmodul angeordnet, die zumindest teilweise in der Ebene des Solarmoduls liegt. Mit der Positionierhilfe ist eine Positionierung und/oder Fixierung des Solarmoduls möglich. Durch die berührungs- oder kontaktlose Halterung des Solarmoduls durch die Halteeinrichtung, könnte das Solarmodul seitlich verschoben werden. Zur Vermeidung seitlicher Bewegungen dient die Positionierhilfe als Anschlagkante, mit der das Solarmodul seitlich gehalten wird. Hieraus ergibt sich vorteilhaft die Möglichkeit, die gesamte Oberseite mit einer Beschichtung zu beschichten und diese auch durch den Laser zu bearbeiten.

Weitere vorteilhafte Ausgestaltungen der Vorrichtung ergeben sich aus den Unteransprüchen.

Ein bevorzugtes Ausführungsbeispiel der Erfindung wird nachfolgend anhand der Zeichnung näher erläutert. In dieser zeigen:
- Fig. 1: eine perspektivische Seitenansicht der erfindungsge- mäßen Vorrichtung von einer ersten Längsseite,
- Fig. 2: eine perspektivische Seitenansicht der erfindungsge- mäßen Vorrichtung von einer zweiten Längsseite,
- Fig. 3: eine perspektivische Ansicht von unterhalb der erfin- dungsgemäßen Vorrichtung,
- Fig. 4: eine Draufsicht auf die erfindungsgemäße Vorrichtung,
- Fig. 5: eine Vorderansicht der erfindungsgemäßen Vorrichtung, und
- Fig.: 6 eine ausschnittsweise Ansicht des Strukturierungs- werkzeugs mit Halteeinrichtung.

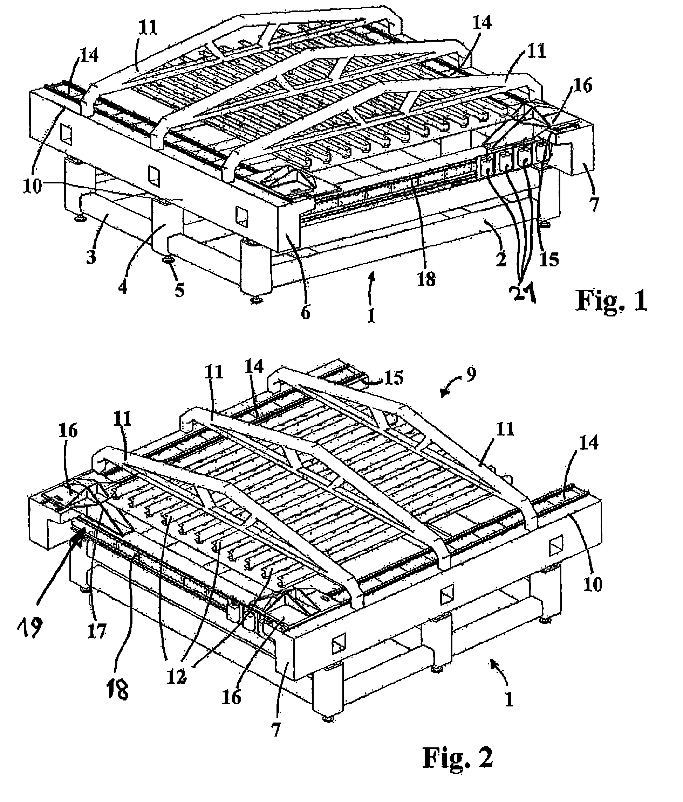

Fig. 1 und 2 der Zeichnung zeigen die erfindungsgemäße Vorrichtung von einer ersten und zweiten Längsseite in perspektivischer Ansicht. Die Vorrichtung weist ein Untergestell 1 auf, das aus Querstreben 2, Längsstreben 3 und Füßen 4 gebildet ist. Das Untergestell 1 ist nach Art eines Kreuztisches gebildet. An den Unterseiten der Füße 4 sind Justierungen 5 angeordnet, mit denen Unebenheiten des darunter liegenden Untergrunds ausgeglichen werden können.

Auf jeweils drei an Längsseiten des Untergestells 1 befindlichen Füßen 4 sind seitliche Lagerelemente 6, 7 angeordnet. Die Füße 4 bilden auf ihrer Oberseite eine waagerechte Ebene, wodurch die Lagerelemente 6, 7 waagerecht gelagert sind. Mittels der Justierungen 5 an den Füßen 4 kann für eine waagerechte Lagerung das Untergestell 1 nachjustiert werden. Zusätzlich ist zwischen den Füße 4 und den Lagerelementen 6, 7 jeweils ein Verbindungselement positioniert. Das Verbindungselement dient der Verbindung zwischen einem Fuß 4 und dem Lagerelement 6, 7. Das jeweilige Verbindungselement weist ebenfalls eine Justiermöglichkeit auf, mit der zusätzlich die Lagerelemente 6 und 7 in eine waagerechte Position gebracht werden können.

Die Lagerelemente 6, 7 sind massiv ausgebildet und weisen einen geringen Wärmeausdehnungskoeffizienten auf. Das Lagerelement 6, 7 ist als ein umgekehrter L-Träger ausgebildet. Die Unterseite des L dient als Oberseite des Lagerelements 6, 7, wobei jeweils eine Innenseite der zueinanderstehenden Schenkel des Lagerelements 6, 7 in Richtung des jeweiligen anderen Lagerelements 6, 7 weist. Das auf den Füßen 4 aufliegenden Teil des Lagerelements 6, 7 ist in seinen Ausmaßen größer als der andere die Oberseite bildende Schenkel ausgebildet.

Zwischen den sich gegenüberliegenden Lagerelementen 6 und 7 ist eine Halteeinrichtung 9 positioniert. Im Bereich nach jeweils außen stehender Kanten 10 der Lagerelemente 6 und 7 fußen Tragelemente 11, die mit den Lagerelementen 6 und 7 fest verbunden sind. Die Tragelemente 11 erstrecken sich somit über die gesamte Breite der Vorrichtung. Insgesamt sind in den Figuren drei solcher Tragelemente 11 dargestellt, die nebeneinander angeordnet sind. In anderen Ausführungsformen der Vorrichtung kann es indes nötig sein, mehr oder weniger als die dargestellten Tragelemente 11 vorzusehen. Die Tragelemente sind für die Aufnahme von großen Lasten ausgebildet.

Auf einer Unterseite der Tragelemente 11 sind parallel zueinander U-Profile 12 angeordnet. Die U-Profile 12 sind mit einem Schenkel an der Unterseite der Tragelemente 11 angelenkt. An einem anderen Schenkel, der parallel zum mit dem Tragelement 11 verbundenen Schenkel liegt, sind Haltemittel 13 angeordnet. Die Haltemittel 13 liegen auf einer Außenseite des U-Profils 12 und weisen in Richtung Untergestell 1. Ein jeweiliges U-Profil 12 weist eine Mehrzahl von Haltemitteln 13 auf. Die Haltemittel 13 sind mit den U-Profilen an der Unterseite der Tragelemente 11 gleichmäßig verteilt, wobei ein möglichst kleines Raster an Halteelementen 13 vorgesehen ist.

Ebenfalls auf der Oberseite 8 der Lagerelemente 6 und 7 ist eine Führung 14 angeordnet. Die Führung 14 ist in einem Bereich einer inneren Kante 15 der Lagerelemente 6 und 7 angeordnet. Die Führungen 14 verlaufen exakt parallel zueinander. In den jeweiligen Führungen 14 der Lagerelemente 6 und 7 werden Fahrgestelle 16 geführt. Die Fahrgestelle 16 erstrecken sich zumindest teilweise oberhalb der Führungen 14 und werden nach oben durch die Tragelemente 11 begrenzt. Die Tragelemente 11 sind im Bereich der Führungen 14 von diesen beabstandet. Das Fahrgestell 16 kann somit zwischen den Tragelementen 11 und der Führung 14 hindurchgeführt werden.

Das Fahrgestell 16 ist breiter als die Führung 14 ausgebildet und überragt die innere Kante 15. Seitlich an dem Fahrgestell 16 ist eine Halterung 17 angeordnet, die nach unterhalb des nach innen weisenden Schenkels des Tragelements 6, 7 sich erstreckt. Dabei erstreckt sich die Halterung 17 auch nach oberhalb des Fahrgestells 16, liegt also auf dem Fahrgestell auf. An eine Unterseite der jeweiligen Halterungen 17 ist ein Träger 18 angelenkt, der sich zwischen den Halterungen 17 erstreckt und diese miteinander verbindet. Die Konstruktion aus Fahrgestell 16, Halterung 17 und Träger 18 bildet einen sogenannten Wagen 19. Die Halterung 17 erstreckt sich vertikal von dem Fahrgestell 16 zum Träger 18 entlang der inneren Kante 15. Der Träger 18 selbst erstreckt sich seitlich nach außen über die jeweiligen Halterungen 17. Der Träger 18 liegt somit zumindest teilweise unterhalb der Oberseite 8 und der Führung 14. Seitlich begrenzt wird der Träger 18 durch den mit den Füßen 4 verbundenen Schenkel der Lagerelemente 6 und 7.

Der Träger 18 weist ebenfalls eine Führung auf, die in erfindungsgemäßen Ausführungsbeispiel als Schiene ausgebildet ist. Die Schiene 20 verläuft über die gesamte Länge des Trägers 18. Die Schiene 20 ist an einer Außenseite des Trägers angelenkt, wobei sie auf einer Außenseite des Trägers 18 mit diesem verbunden ist.

An dem Träger 18 sind eine Mehrzahl von Lasern 21 angeordnet. Die Laser 21 sind beweglich mit der Schiene 20 verbunden. Die Laser 21 sind seitlich an dem Träger 18 über die Breite der Vorrichtung beweglich. Die Laser sind in jeweiligen Boxen untergebracht, die einzeln mit der Schiene 20 verbunden sind. Somit lassen sich die Laser 21 einzeln oder im Verbund über den Träger 18 bewegen. Die Laser 21 sind in Richtung der Halteeinrichtung 9 ausgerichtet. Ein Laserstrahl der jeweiligen Laser 21 verläuft somit in vertikaler Richtung.

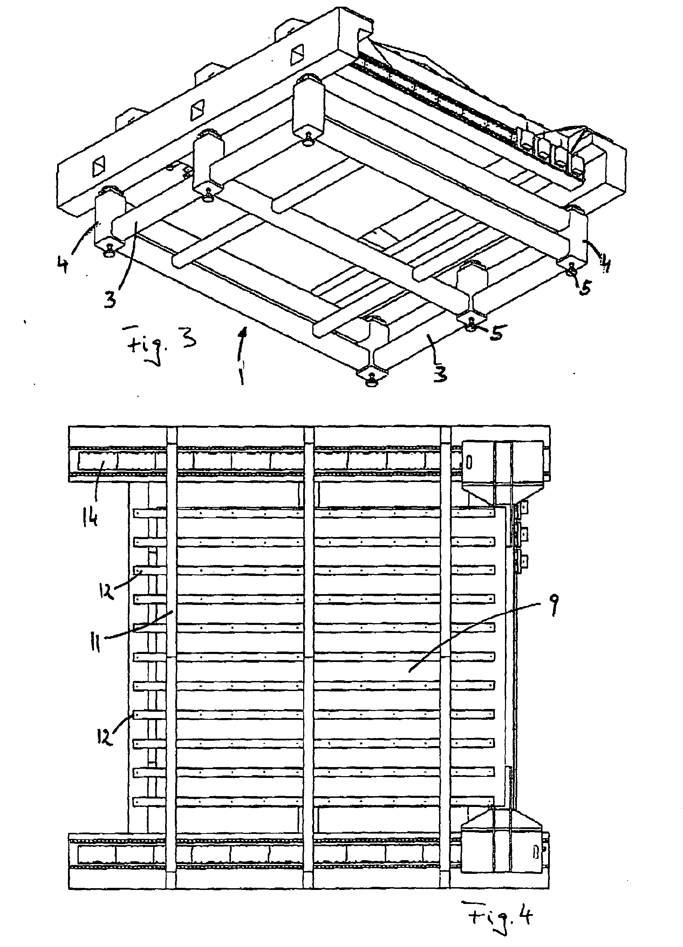

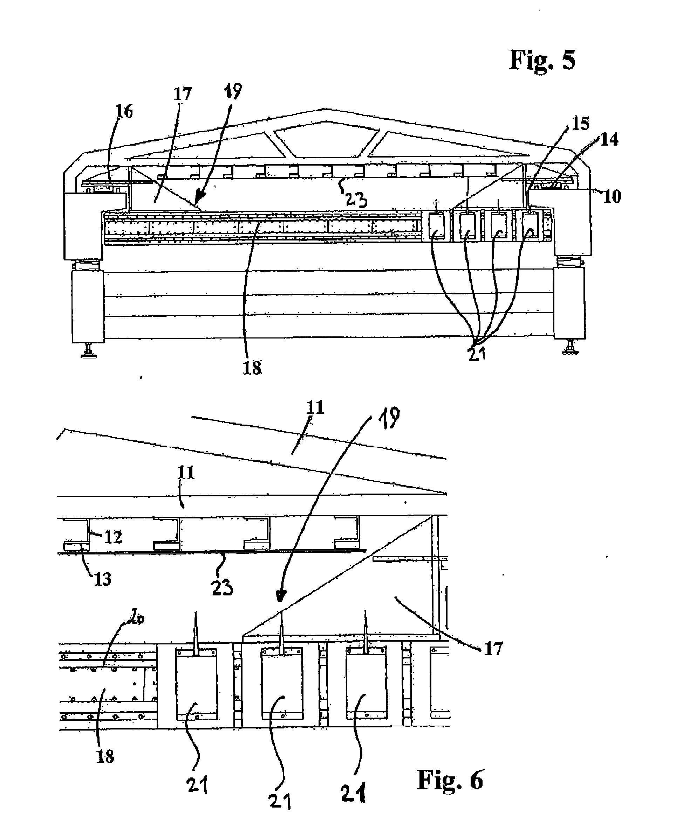

Der Wagen 19 mit den an dem Träger 18 angelenkten Lasern 21 ist in einer Längserstreckung der Vorrichtung, also entlang der Lagerelemente 6 und 7, beweglich. Gleichzeitig lassen sich die Laser 21 quer zu dieser Bewegung verfahren. In dem in den Fig. 1-6 gezeigten Ausführungsbeispiel sind jeweils vier Laser 21 auf dem Träger 18 angeordnet. In weiteren Ausführungen der Erfindung sind aber auch mehr oder weniger Laser vorgesehen.

Die Halteeinrichtung 9 dient der Halterung eines aus Flachglas bestehenden Solarmoduls 23. Das Solarmodul 23 wird dabei von den Haltemitteln 13 unterhalb der Halteeinrichtung 9 gehalten. Die Haltemittel 13 sind als sogenannte Bernoulli-Greifer ausgeführt. Die Bernoulli-Greifer erzeugen durch auf eine Oberfläche des Moduls geblasenen Luftstrom einen Unterdruck, womit das angeblasenes Solarmodul in Richtung der Bernoulli-Greifer gesogen wird. Durch die Vielzahl der auf der Halteeinrichtung 9 positionierten als Bernoulli-Greifer ausgebildeten Haltemittel 13 können große Objekte, wie beispielsweise ein Solarmodul 23, gehaltert werden. Durch den entweichenden Luftstrom, der durch die Bernoulli-Greifer auf die Oberfläche des Solarmoduls 23 geblasen wird, findet keine Berührung zwischen Solarmodul 23 und Haltemittel 13 statt. Zwischen Solarmodul 23 und den Bernoulli-Greifern bleibt ein kleiner Spalt, durch den die entweichende Luft seitlich bzw. radial abströmt.

Das Solarmodul 23 weist auf der angeblasenen Oberseite eine Beschichtung auf, die in Richtung der Haltemittel 13 weist. Zur Strukturierung dieser Beschichtung werden die Laser 21 unterhalb des Solarmoduls 23 auf dem Wagen 19 über die Ausmaße des Solarmoduls 23 verfahren. Das Solarmodul 23 ist kleiner als eine durch die Lagerelemente 6 und 7 aufgespannte Ebene, wodurch die Laser 21 die gesamte Fläche des Solarmoduls 23 erreichen. Die Laser 21 brennen von unterhalb des Solarmoduls eine Strukturierung in die Beschichtung in Form von Unterbrechungen, wobei die Beschichtung verbrennt bzw. verdampft. Durch die berührungslos Halterung des Solarmoduls 23 kann somit auch im Bereich der Haltermittel 13 (Bernoulli-Greifer) der Strukturierungsvorgang erfolgen. Auf einer Verschiebung des Solarmoduls 23 und des Haltemittels 13 kann somit verzichtet werden. Durch den Luftstrom, der durch die Bernoulli-Greifer auf die Oberfläche des Solarmoduls 23 geblasen wird, werden Partikel, die durch die Verbrennung der Beschichtung entstehen, abgeführt. Zusätzlich werden auch bei der Verbrennung entstehende Gase weggeblasen. Nicht dargestellt ist eine oder mehrere Absaugvorrichtungen, die sowohl überhalb der Halteeinrichtung 9 als auch seitlich dazu angeordnet sind. Eine Absaugeinrichtung nimmt die durch die Bernoulli-Greifer weggeblasenen Partikel und Gase auf.

Nicht in den Figuren dargestellt ist eine Positionierhilfe, die seitlich das Solarmodul in Stellung hält. Durch die berührungslose Halterung des Solarmoduls 23 durch die Halteeinrichtung 9 kann das Solarmodul 23 durch externe Einflüsse verschoben werden. Für die Strukturierung der Beschichtung des Solarmoduls 23 ist es jedoch wichtig, dass das Solarmodul 23 in Stellung gehalten wird. Die Positionierhilfe kann dabei aus einem Stift oder jeglich anderen Mitteln zur Positionierung bestehen, der seitlich an das Solarmodul 23 herangeführt wird. Vorgesehen ist, dass das Solarmodul 23 in jegliche Richtung gesichert ist.

In einem anderen nicht dargestellten Ausführungsbeispiel ist die Halteeinrichtung 9 parallel zu einer Ebene des Solarmoduls 23 drehbar. Dabei ist es ausreichend, dass das Solarmodul 23 um 90° in Uhrzeigerrichtung oder entgegen der uhrzeigerrichtung gedreht wird. Die Strukturierung eines Solarmoduls ist sehr komplex, so dass durch die Drehung der Halteeinrichtung 9 mit dem Solarmodul 23 die Bearbeitungszeit verkürzt werden kann.

Die Strukturierung mit den Lasern 21 erfordert eine genaue Führung der Laser 21 unterhalb des Solarmoduls 23. Das Verbrennen der Beschichtung auf der Oberseite des Solarmoduls 23 erfolgt nämlich nur in einem Fokussierungsbereich des Laserstrahls. Zur Vermeidung von Ungenauigkeiten der Führung des Lasers ist es unter anderem vorgesehen, das Solarmodul 23 auf Höhe der Führung 14 zu halten. Zumindest aber ist vorgesehen, dass eine Drehachse des Wagens 19 auf der Ebene des Solarmoduls 23 liegt. Durch diese Anordnung bleibt der Fokussierungsbereich des Lasers 21 stabil im Bereich der Beschichtung des Solarmoduls 23.

## Patentansprüche

1. Vorrichtung zur Strukturierung eines vorzugsweise eine Glasplatte aufweisenden Solarmoduls (23) mit einer Halteeinrichtung (9), die das Solarmodul (23) haltert, und wenigstens einem Strukturierungswerkzeug zur Strukturierung zumindest einer auf dem Solarmodul befindlichen Beschichtung, wobei das Solarmodul auf einer dem Strukturierungswerkzeug abgewandten Oberseite berührungslos gehaltert wird,
die Halteeinrichtung (9)ein oder mehrere Haltemittel (13) aufweist, wobei durch das jeweilige Haltemittel (13) zur Halterung des Solarmoduls (23) auf der Oberseite des Solarmoduls (23) mittels Druckluft ein Unterdruck erzeugbar ist, **dadurch gekennzeichnet, dass** das Strukturierungswerkzeug wenigstens einen Wagen (19) und wenigstens einen Laser (21) umfasst, wobei der jeweilige Laser (21) zweidimensional unter dem jeweiligen Solarmodul (23) bewegbar ist.

2. Vorrichtung nach Anspruch 1, **dadurch gekennzeichnet,**
**dass** das Strukturierungswerkzeug mehrere Laser (21) umfasst, wobei die jeweiligen Laser unterhalb der Halteeinrichtung (9) angeordnet sind und derart gehalten sind, dass die Laser (21) zweidimensional unter dem jeweiligen Solarmodul (23) bewegbar sind.

3. Vorrichtung nach zumindest einem der Ansprüche 1 bis 2,
**dadurch gekennzeichnet, dass** das Strukturierungswerkzeug beweglich unterhalb der Halteeinrichtung (9) angeordnet ist.

4. Vorrichtung nach zumindest einem der Ansprüche 1 bis 3,
**dadurch gekennzeichnet, dass** der jeweilige Laser (21) in einer Längs- und einer Querrichtung des jeweiligen Solarmoduls (23) beweglich ist.

5. Vorrichtung nach zumindest einem der Ansprüche 1 bis 4, **dadurch gekennzeichnet, dass** der Wagen (19) einen Träger (18) aufweist, an dem der jeweilige Laser (21) angeordnet ist und der auf zwei parallellaufenden Führungen (14) in Längsrichtung des jeweiligen Solarmoduls (23) verfahrbar ist, wobei der jeweilige Laser (21) an dem Träger (18) quer zur Längserstreckung der Führungen (14) verfahrbar ist.

6. Vorrichtung nach Anspruch 5, **dadurch gekennzeichnet, dass** der Träger (18) an jeweils einem freien Enden ein Fahrgestell (16) aufweist, das mit einer der Führungen (14) korrespondiert.

7. Vorrichtung nach zumindest einem der Ansprüche 5 oder 6, **dadurch gekennzeichnet, dass** die Führung (14) in einer Ebene mit dem Solarmodul (23) angeordnet ist.

8. Vorrichtung nach zumindest einem der Ansprüche 1 bis 7, **dadurch gekennzeichnet, dass** ein Raum unterhalb eines Bearbeitungsbereichs des Strukturierungswerkzeuges frei bleibt.

9. Vorrichtung nach zumindest einem der Ansprüche 1 bis 8, **dadurch gekennzeichnet, dass** die Halteeinrichtung (9) um 90° parallel zur Ebene des Solarmoduls (23) frei drehbar ist.

10. Vorrichtung nach zumindest einem der Ansprüche 1 bis 9, **dadurch gekennzeichnet, dass** die Haltereinrichtung (9) der Absaugung von durch die Laser (23) verdampften Schichtpartikeln dient.

11. Vorrichtung nach zumindest einem der Ansprüche 1 bis 9, **dadurch gekennzeichnet, dass** eine Positionierhilfe seitlich zum Solarmodul (23) angeordnet ist, die zumindest teilweise in der Ebene des Solarmoduls liegt, zur Positionierung und/oder Fixierung des Solarmoduls.

12. Vorrichtung nach einem der Ansprüche 1-11, wobei das jeweilige Solarmodul (23) mittels des jeweiligen Haltemittels (13) ansaugbar ist und gleichzeitig mittels der Druckluft ein Luftkissen erzeugbar ist, sodass das jeweilige Solarmodul (23) unterhalb der Halteeinrichtung (9) haltbar ist.

13. Vorrichtung nach einem der Ansprüche 1-12, wobei der Unterdruck nach einem Bernoulli-Effekt erzeugbar ist.

## Claims

1. A device for structuring a solar module (23) preferably comprising a glass plate, with a holding device (9) which holds the solar module (23) and at least one structuring tool for structuring at least one coating present on the solar module, wherein the solar module is held in a contactless manner on an upper side facing away from the structuring tool,
the holding device (9) comprises one or more holding means (13), wherein an underpressure can be generated by means of compressed air through the respective holding means (13) for holding the solar panel (23) on the upper side of the solar module (23), **characterised in that** the structuring tool comprises at least one carriage (19) and at least one laser (21), wherein the respective laser (21) can be moved two-dimensionally beneath the respective solar module (23).

2. The device according to claim 1, **characterised in that** the structuring tool comprises a plurality of lasers (21), wherein the respective lasers are disposed beneath the holding device (9) and are held in such a way that the lasers (21) can be moved two-dimensionally beneath the respective solar module (23).

3. The device according to at least one of claims 1 to 2, **characterised in that** the structuring tool is disposed in a mobile manner beneath the holding device (9).

4. The device according to at least one of claims 1 to 3, **characterised in that** the respective laser (21) is mobile in a longitudinal and a transverse direction of the respective solar module (23).

5. The device according to at least one of claims 1 to 4, **characterised in that** the carriage (19) comprises a support (18), on which the respective laser (21) is disposed and which can be traversed on two parallel-running guides (14) in the longitudinal direction of the respective solar module (23), wherein the respective laser (21) can be traversed on the support (18) at right angles to the longitudinal extension of the guides (14).

6. The device according to claim 5, **characterised in that** the support (18) comprises in each case on a free end an undercarriage (16), which corresponds to one of the guides (14).

7. The device according to at least one of claims 5 or 6, **characterised in that** the guide (14) is disposed in a plane with the solar module (23).

8. The device according to at least one of claims 1 to 7, **characterised in that** a space remains free beneath a machining region of the structuring tool.

9. The device according to at least one of claims 1 to 8, **characterised in that** the holding device (9) can be freely rotated through 90° parallel to the plane of the solar module (23).

10. The device according to at least one of claims 1 to 9, **characterised in that** the holding device (9) is used for the removal by suction of layer particles vapour-deposited by the laser (23).

11. The device according to at least one of claims 1 to 9, **characterised in that** a positioning aid is disposed at the side of the solar module (23), said positioning aid lying at least partially in the plane of the solar module, for the purpose of positioning and/or fixing the solar module.

12. The device according to any one of claims 1-11, wherein the respective solar module (23) can be engaged by suction by means of the respective holding means (13) and an air cushion can be generated at the same time by means of the compressed air, so that the respective solar module (23) can be held beneath the holding device (9).

13. The device according to any one of claims 1-12, wherein the underpressure can be generated by a Bernoulli effect.

## Revendications

1. Dispositif de structuration d'un module solaire (23) présentant de préférence une plaque de verre comportant un dispositif de retenue (9), qui retient le module solaire (23), et au moins un outil de structuration à des fins de structuration d'au moins un revêtement se trouvant sur le module solaire, dans lequel le module solaire est retenu sans contact sur un côté supérieur qui se détourne de l'outil de structuration,
le dispositif de retenue (9) présente un ou plusieurs moyens de retenue (13), dans lequel une dépression peut être générée au moyen d'air pressurisé à travers le moyen de retenue (13) respectif pour retenir le module solaire (23) sur le côté supérieur du module solaire (23), **caractérisé en ce que** l'outil de structuration comprend au moins un chariot (19) et au moins un laser (21), dans lequel le laser respectif (21) peut être déplacé en deux dimensions sous le module solaire respectif (23).

2. Dispositif selon la revendication 1, **caractérisé en ce que** l'outil de structuration comprend plusieurs lasers (21), dans lequel les lasers respectifs sont disposés en dessous du dispositif de retenue (9) et sont maintenus de telle sorte que les lasers (21) puissent être déplacés en deux dimensions sous le module solaire respectif (23).

3. Dispositif selon au moins une des revendications 1 à 2, **caractérisé en ce que** l'outil de structuration est disposé de manière mobile en dessous du dispositif de retenue (9).

4. Dispositif selon au moins une des revendications 1 à 3, **caractérisé en ce que** le laser respectif (21) est mobile dans une direction longitudinale et une direction transversale du module solaire respectif (23).

5. Dispositif selon au moins une des revendications 1 à 4, **caractérisé en ce que** le chariot (19) présente un support (18), sur lequel le laser respectif (21) est disposé et qui peut être déplacé sur deux glissières (14) s'étendant en parallèle dans la direction longitudinale du module solaire (23) respectif, dans lequel le laser respectif (21) peut être déplacé sur le support (18) transversalement à l'extension longitudinale des glissières (14).

6. Dispositif selon la revendication 5, **caractérisé en ce que** le support (18) présente sur une extrémité libre respective un châssis (16), qui correspond à une des glissières (14).

7. Dispositif selon au moins une des revendications 5 ou 6, **caractérisé en ce que** la glissière (14) est disposée dans un plan avec le module solaire (23).

8. Dispositif selon au moins une des revendications 1 à 7, **caractérisé en ce que** un espace reste à découvert en dessous d'une zone d'usinage de l'outil de structuration.

9. Dispositif selon au moins une des revendications 1 à 8, **caractérisé en ce que** le dispositif de retenue (9) est rotatif librement de 90° parallèlement au plan du module solaire (23).

10. Dispositif selon au moins une des revendications 1 à 9, **caractérisé en ce que** le dispositif de retenue (9) sert à l'aspiration des particules de couche évaporées par le laser (23).

11. Dispositif selon au moins une des revendications 1 à 9, **caractérisé en ce que** un auxiliaire de positionnement est disposé latéralement au module solaire (23), lequel est situé au moins partiellement dans le plan du module solaire, à des fins de positionnement et/ou fixation du module solaire.

12. Dispositif selon une des revendications 1 à 11, dans lequel le module solaire respectif (23) peut être aspiré au moyen du moyen de retenue respectif (13) et un coussin d'air peut être simultanément généré au moyen de l'air pressurisé, de telle sorte que le module solaire respectif (23) puisse être retenu en dessous du dispositif de retenue (9).

13. Dispositif selon une des revendications 1 à 12, dans lequel la dépression peut être générée selon un effet Bernoulli.
